Europäisches Patentamt

European Patent Office

Office européen des brevets

(19)

(11) Publication number: **0 014 080**
**B1**

(12) # EUROPEAN PATENT SPECIFICATION

(45) Date of publication of patent specification: **02.11.83**

(51) Int. Cl.³: **H 01 L  29/74**

(21) Application number: **80300171.8**

(22) Date of filing: **18.01.80**

(54) A three-terminal semiconductor switch device.

(30) Priority: **19.01.79 JP 3970/79**

(43) Date of publication of application:
**06.08.80 Bulletin 80/16**

(45) Publication of the grant of the patent:
**02.11.83 Bulletin 83/44**

(84) Designated Contracting States:
**DE GB**

(56) References cited:
**FR - A - 2 394 175**

(73) Proprietor: **Hitachi, Ltd.**
**5-1, Marunouchi 1-chome**
**Chiyoda-ku Tokyo 100 (JP)**

(72) Inventor: **Terasawa, Yoshio**
**622-19, Ichige**
**Katsuta Ibanaki (JP)**
Inventor: **Oikawa, Saburo**
**394-31, Kuji**
**Hitachi Ibanaki (JP)**

(74) Representative: **Ellis, Edward Lovell et al,**
**MEWBURN ELLIS & CO. 2/3 Cursitor Street**
**London EC4A 1BQ (GB)**

Courier Press, Leamington Spa, England.

## A three-terminal semiconductor switch device

The present invention relates to a three-terminal semiconductor switch device which has a pair of main electrodes and one control electrode.

Transistors and field controlled thyristors have been used as semiconductor devices in which a load and a power supply are connected across a pair of electrodes, the current flowing therethrough being controlled by applying a control voltage to the control electrode of the semiconductor device. Such semiconductor devices can be used as contactless switches for electric machines and other electrical appliances.

In a conventional transistor, the emitter and the collector electrodes constitute said pair of electrodes, and the base electrode is the control electrode. In, for example, an NPN-type transistor, a power supply and a load are connected in series across the collector electrode and the emitter electrode, the collector electrode being connected to the positive side of the power supply.

In this case, a base voltage biasing potential is connected across the base electrode and the emitter electrode so as to render the base electrode positive potential, with respect to the emitter electrode, so that the PN-junction across the emitter and base electrodes is accordingly forward-biased to conduct a base current, whereby electrons are injected from an emitter layer via a base layer into a collector layer. As a result, the PN-junction across the base layer and the collector layer having been reverse-biased by the power supply and formed with a depletion layer becomes forward-biased and the path between the emitter electrode and collector electrode of the transistor has a low impedance, so that current determined by the supply voltage and the load flows from the collector electrode towards the emitter electrode. This current is called the collector current and corresponds to the "on" state of the device. By removing the forward bias of the PN-junction across the emitter and the base electrodes, the path between the emitter electrode and the collector electrode has a high impedance, and the current across the emitter electrode and the collector electrode is interrupted and corresponds to the "off" state of the device.

In order to raise the forward blocking voltage of the transistor as described above, the collector layer and the base layer must be thickened. However, when both these layers are made thick, the number of carriers reaching the collector layer from the emitter layer decreases. Accordingly, in order to render the transistor in the "on" state, a large base current is required, which is not practical. This is the major reason why a transistor having a high breakdown voltage and a large capacity is not yet available on the market.

A known type of field controlled thyristor will now be described. The field controlled thyristor is, for example, the one disclosed in the specification of U.S. Patent No. 4,060,821 wherein a cathode electrode and an anode electrode are the said pair of electrodes, whilst a gate electrode is the control electrode. In such a device, the power supply and the load are connected in series across the cathode and more electrodes, the anode electrode being connected to the positive side of the power supply. In this case, if the gate electrode is open-circuited, the PN-junction across the cathode electrode and the anode electrode is forward-biased, and the current, which is determined by the supply voltage and the load flows from the anode electrode to the cathode electrode, this corresponding to the "on" state of the device.

A gate voltage source is connected across the gate electrode and the cathode electrode so as to render the gate electrode negative with respect to the cathode electrodes, thus enabling a depletion layer to be formed across a cathode layer and an anode layer. Thus, the path between the cathode electrode and the anode electrode reaches a high impedance, so that no current flows across these electrodes, this corresponding to the "off" state of the device.

Such a field controlled thyristor has the disadvantage that, since a PN-junction which lies across the anode layer and a base layer having the same conductivity type as that of the cathode layer is forward-biased at all times, the period of time required for interrupting the main current across the cathode electrode and the anode electrode becomes long.

In the field controlled thyristor, the interrupting of the main current is performed as outlined below. When a reverse bias voltage is applied across the gate electrode and the cathode electrode, carriers in the vicinity of the PN-junction across the cathode layer and a gate layer are first swept out into the gate electrode through the gate layer, and hence, this PN-junction is formed with a depletion layer. When the depletion layer pinches off the path between the cathode electrode and the anode electrode within the base layer, the main current is interrupted. Since, however, the supply voltage is still applied across the anode electrode and the cathode electrode, the PN-junction across the base layer and the anode layer is forward-biased, and holes are injected from the anode layer into the base layer. As a result, the formation of the depletion layer in the PN-junction across the cathode layer and the gate layer becomes slow, and the main current cannot be quickly interrupted.

Another type of field controlled thyristor is disclosed in United States Patent Specification No. 4,223,328, corresponding to French Specification No. 2,394,175. This specification discloses a field controlled thyristor which comprises a first emitter region exposed to one main surface of a semiconductor substrate and having a first conductivity type, a second emitter region exposed to the other main surface of the substrate and having a second conductivity type, a base region connecting the first and the second emitter region, and a gate region provided in the base region. The gate region consists of a slab-like first portion disposed parallel to both the emitter and a second portion connecting the first slab-like portion with one of the main surfaces of the semiconductor substrate. The impurity concentration of the base region is higher in the portion of the base region nearer to the emitter region having the same conductivity type as that of the base region than in the portion of the base region nearer to the emitter region having the opposite conductivity type to that of the base region.

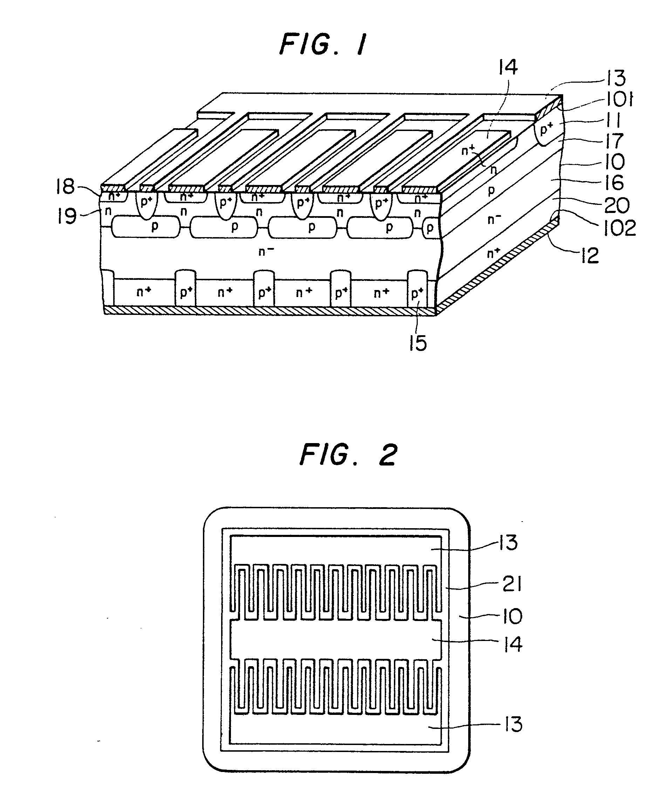

In Figure 2A of this Specification a $N^+NN^-P^+$ type diode is surrounded by $N^+NPN^-P$ type thyristors. Also in Figure 7, a $N^+NN^-N^+$ region is surrounded by $N^+NPN^-P^+$ type thyristors. These arrangements suffer from the same effects as referred to above in connection with U.S. Patent Specification No. 4,060,821.

According to the present invention there is provided a semiconductor switch device comprising a semiconductor body, a pair of main electrodes and a control electrode which are connected to said semiconductor body;

said semiconductor body has a pair of opposing major surfaces and which includes: a first semiconductor region of one conductivity type which is exposed to one of said major surfaces;

a second semiconductor region of said opposite conductivity type which adjoins said first semiconductor region and forms a first p-n junction with said first semiconductor region;

a third semiconductor region of said one conductivity type which adjoins said first and second semiconductor regions and forms a second p-n junction with said second semiconductor region, and forms a channel region with said first semiconductor region;

a fourth semiconductor region which adjoins said third semiconductor region, and is exposed to the other major surface of said semiconductor body,

said first main electrode is connected to said first semiconductor region of said semiconductor body;

said second main electrode is connected to said fourth semiconductor regions of said semiconductor body; and

said control electrode is connected to said second semiconductor region of said semiconductor body;

characterized in that said switch device includes the following features:

said fourth semiconductor region is said one conductivity type and has an impurity concentration higher than that of said third semiconductor region;

said semiconductor body has a fifth semiconductor region of a conductivity type which is opposite to said channel region across said third semiconductor region forming a third p-n junction and adjoins said fourth semiconductor region, said fifth semiconductor region is exposed to the other major surface of said semiconductor body and is connected to said second main electrode, thereby constituting a diode between said pair of major surfaces with said first semiconductor region, said third semiconductor region including said channel region and said fifth semiconductor region, and also constituting a transistor between said pair of major surfaces with said first semiconductor region, said second semiconductor region, said third semiconductor region and said fourth semiconductor region.

The present invention will now be described in greater detail by way of example with reference to the accompanying drawings, wherein:—

Figure 1 is a perspective view, partly in section, of one preferred form of a semiconductor switch device;

Figure 2 is a plan view of the semiconductor switch device shown in Figure 1;

Figure 3 is a sectional view showing on enlarged scale the essential portions of the semiconductor switch device of Figure 1, with the addition of circuit connections for explaining the operation of the device; and

Figures 4 and 5 are sectional views similar to that of Figure 3, showing the essential portions of two further embodiments of semiconductor switch devices.

Referring to Figures 1 to 3, the first embodiment relates to a 600 V, 20 A-type field controlled semiconductor switch device having an interdigitated electrode structure. The semiconductor switch device comprises a silicon body 10 having a pair of major surfaces 101 and 102 between which are formed the following semiconductor regions; an $n^+$-type semiconductor layer 20 which is exposed on the major surface 102; an $n^-$-type semiconductor layer 16 which adjoins the $n^+$-type layer 20; a p-type semiconductor layer 17 which adjoins the $n^-$-type layer 16; a $p^+$-type region 11 which couples the p-type layer 17 and the major surface 101; an n-type layer 19 which is surrounded by the p-type layer 17 and the $p^+$-type region 11; and an $n^+$-type layer 18 which adjoins the n-type layer 19 and which is exposed to the major surface 101. A part of that portion of the p-type layer 17 which is opposite to the $n^+$-type layer 18 is omitted along the longitudinal direction of the $n^+$-type layer 18, so that the $n^-$-type layer 16 and the n-type layer 19 are in direct contact along this part. This part will hereinafter be referred to as the channel. That portion of the $n^+$-type layer 20 which is opposite to the channel is replaced with a $p^+$-type region 15.

A first main electrode 14 is formed on the portion of the $n^+$-type layer 18 exposed on one major surface 101 of the semiconductor body 10, whilst a control electrode 13 is formed on the exposed portion of the $p^+$-type region 11. The other main electrode 12 is formed on the other major surface 102 of the semiconductor body 10. These electrodes can be made from aluminium films.

Referring now to figure 2, it will be seen that the first main electrode 14 and the control electrode 13 are interdigitated. A silicon dioxide film 21 covers that area of the major surface 101 which is not covered with the electrode, the film 21 being omitted in Figure 1 for the sake of clarity. The semiconductor body 10 is in the shape of a square whose sides are approximately 6.3 mm long.

The semiconductor device can be produced by employing the diffusion process and the epitaxial growth process as follows. First, an n-type silicon substrate whose resistivity is approximately 50 ohm-cm is prepared, and phosphorus is diffused from one major surface of the substrate so as to form the $n^+$-type layer 20. Subsequently, boron is diffused into selective areas of the pair of major surfaces, to form the p-type layer 17 and the $p^+$-type region 15. At the next step, the n-type layer 19 is deposited by epitaxial growth on the entire major surface formed with the p-type layer 17. From the surface of the n-type layer 19 boron is selectively diffused to form the $p^+$-type region 11 reaching the p-type layer 17, whereupon the $n^+$-type layer 18 is formed by the selective diffusion of phosphorus.

Thereafter, the silicon dioxide film 21 is formed so as to cover the peripheral edges of the exposed surface portions of the $p^+$-type region 11 and the $n^+$-type layer 18, whilst the first main electrode 14, the control electrode 13 and the other main electrode 12 are respectively formed on the exposed surface portion of the $n^+$-type layer 18, the exposed surface portion of the $p^+$-type region 11 and the exposed surface portions of the $n^+$-type layer 20 and the $p^+$-type regions 15 of the semiconductor body by evaporating aluminium.

The dimensions and impurity concentrations of the various portions of the semiconductor device thus formed are as stated below. Regarding the thicknesses of the respective semiconductor layers, the $n^+$-type layer 18 is 4 $\mu$m thick, the n-type layer 19 is 10 $\mu$m thick, the p-type layer 17 is 40$\mu$m thick, the $n^-$-type layer 16 is 140 $\mu$m thick, the $p^+$-type layer 15 is 20 $\mu$m thick, and the $n^+$-type layer 20 is 10 $\mu$m thick. The resistivity of the $n^-$-type layer 16 is 50 ohm-cm (corresponding to approximately $1 \times 10^{14}$ cm$^{-3}$) as stated previously, the impurity concentration of the n-type layer 19 is $2 \times 10^{15}$

cm$^{-3}$. Regarding the surface impurity concentrations of the other semiconductor layers immediately after the diffusion steps, the $n^+$-type layer 18 has a value of $2 \times 10^{20}$ cm$^{-3}$, the p-type layer 17 has a value of $5 \times 10^{17}$ cm$^{-3}$, and the $p^+$-type regions 11 and 15 and the $n^+$-type layer 20 have values of $1 \times 10^{19}$ cm$^{-3}$. The $n^+$-type layer 18 is 50 $\mu$m wide and 1,200 $\mu$m long, and the width of the channel is approximately 7 $\mu$m, which is substantially equal to the width of the $p^+$-type region 15. In the semiconductor device described above, seventy four $n^+$-type layers 18 are provided within the semiconductor body.

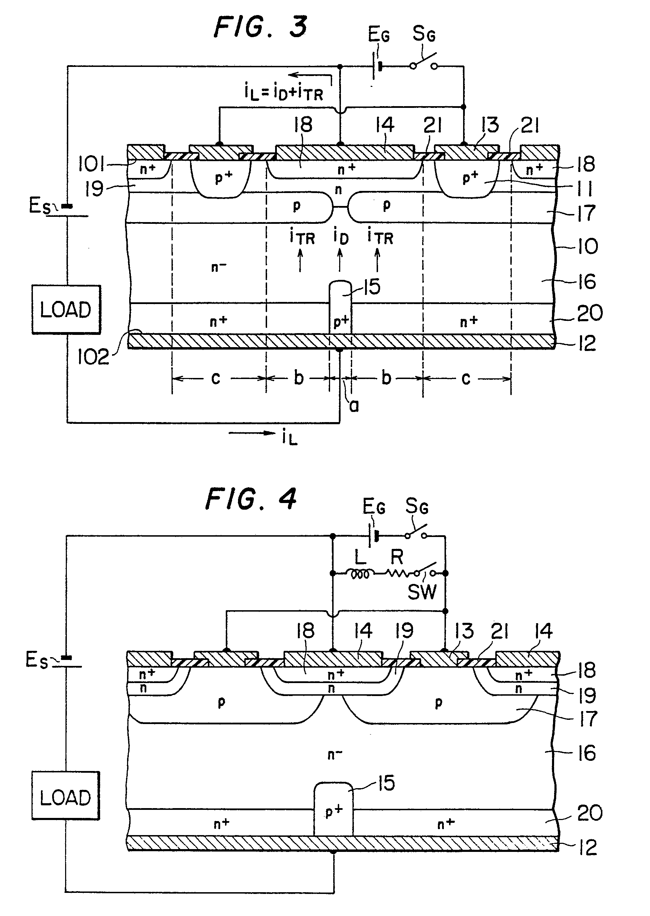

Referring now to Figure 3, an example of the operation of the semiconductor device will now be described in greater detail. A power supply $E_s$ and a load are connected in series across the pair of main electrodes 14 and 12. The polarity of the power supply $E_s$ is such that the first main electrode 14 connected to the $n^+$-type layers 18 is negative with respect to the second main electrode 12. A control power supply $E_G$ and a switch $S_G$ are connected in series across the first main electrode 14 and the control electrode 13. The polarity of the control power supply $E_G$ is such that the first main electrode 14 is positive with respect to the control electrode. A field controlled thyristor can be used as the switch $S_G$.

When the main power supply $E_s$ is connected in the state where the switch $S_G$ is open, that is where no reverse bias is applied across the p-type layer 17 and the $n^+$-type layer 18, a forward current flows through a $p^+n^-nn^+$-diode (region a) formed in the channel portion. This current becomes an intense control current for $n^+n^-pnn^+$ transistors (regions b) formed adjacent to the diode, and injects large quantities of carriers into the base layers and collector layers of the transistors in the lateral directions of the respective layers (directions parallel to junctions). The quantity of carriers injected may be more than $1 \times 10^{16}$ cm$^{-3}$ for a diode current of 10 A/cm$^2$.

As a result, the whole transistor region is rendered conductive. Therefore, even where the base layer of the transistor region is thickened, the carrier transport factor does not become small, and the breakdown voltage can be enhanced.

In the present embodiment, the width of the $p^+$-type region 15 should be set so as to permit the injection of enough carriers to bring the transistor (region b) into the conductive state. Accordingly, in the case where the channel width is small, the width of the $p^+$-type region 15 can become greater than the channel width.

Furthermore, the load current can be interrupted faster than in the prior-art field controlled thyristor.

The reason therefore is as follows. Referring to Figure 3, when the switch $S_G$ is closed, the $n^+npp^+$ diode formed between the first main electrode 14 and the control electrode 13 is reverse-biased by the control power supply $E_G$, and simultaneously, the current having flowed from the second main electrode 12 to the first main electrode 14 till then, begins to flow from the second main electrode 12 via the p-type layer 17 and the $p^+$-type region 11 into the control electrode 13. That is, holes having been injected into the $n^-$-type layer 16, the n-type layer 19 and the p-type layer 17 are swept out into the control electrode 13. In consequence, depletion layers are spread around the p-type layers 17, in order to pinch off the channel. Thereafter, the carriers remaining in the $n^-$-type layer 16 are extinguished by recombination, and the semiconductor device turns to the "off" state.

When the switch $S_G$ is closed in such a turn-off mechanism, a voltage $(E_s+E_G)$ in the case where the power supplies $E_s$ and $E_G$ are connected in series with an $n^+n^-pp^+$ diode (region (b+c)) formed between the second main electrode 12 and the control electrode 13, is applied in the reverse direction. More specifically, any junction to be forward-biased by the forward supply voltage $E_s$ as in the field control thyristor of the prior art does not exist in the region (b+c). Accordingly, the turn-off characteristic is the same as the reverse recovery characteristic of the diode, and the carriers injected into the $n^-$-type layer 16 and the p-type layer 17 are swept out of the device faster than in the transistor of the three-layered structure or the thyristor of the four-layered structure. Therefore, the load current can be interrupted faster than in the prior-art field controlled thyristor. Thus, a high frequency switching device having a large capacity can be achieved.

As an example, in the case where a field controlled thyristor was driven by means of the circuit shown in Figure 3, the field controlled thyristor being the same as the semiconductor device illustrated in Figures 1 to 3 except that the $n^+$-type layer 20 and the $p^+$-type regions 15 were replaced with a $p^+$-type layer being 40 $\mu m$ thick, the turn-off time is reduced from approximately 15 $\mu sec$ to 1 $\mu sec$.

A further feature is that the control current of the $n^+n^-pnn^+$ transistor (portion *b* in Figure 3) is the current flowing through the $p^+n^-nn^+$ diode (portion *a* in Figure 3) which is positioned adjacent to the transistor junction portion. For this reason, even when excessive current flows through the device due to the short-circuit of the load, an increase in the load current results in the injection of a larger quantity of carriers into the transistor junction portion with the result that an abnormal increase in a collector-emitter voltage due to an overload current does not occur.

In the prior-art transistor, the base current must be increased as soon as the overload current begins to flow. Such control is troublesome and uneconomical. The above described semiconductor device is practical in that, even when the overload current flows, the control current of the transistor increases automatically for the reason above described.

In the semiconductor device illustrated in Figures 1 to 3, the $n^+$-type layer 20 functions to short the $p^+$-type regions 15 to the second main electrode 12. The $p^+$-type region 15 is made thicker than the $n^+$-type layer 20. In comparison with the case where both have equal thicknesses, this construction reduces the effect that the $n^+$-type layer 20 shorts the $p^+$-type regions 15 to the second main electrode 12, and hence, the injection efficiency of the holes from the $p^+$-type regions into the $n^-$-type layer becomes higher. As a result, the turn-on time of the semiconductor device is shortened. A similar effect can be achieved by equalizing the thicknesses of the $p^+$-type region 15 and the $n^+$-type layer 20 and making the impurity concentration of the $n^+$-type layer 20 lower than that of the $p^+$-type region.

Additionally the above advantages can be enjoyed in the case where the impurity concentrations and thicknesses of the $n^+$-type layer 20 and the $p^+$-type region 15 are respectively equalized, in the case where the impurity concentrations of both are equalized and where the thickness of the $n^+$-type layer 20 is made greater than that of the $p^+$-type layer 15, and in the case where the thicknesses of both are equalized and where the impurity concentration of the $p^+$-type region 15 is made lower than that of the $n^+$-type layer 20. In the last two cases, the turn-off time can be decreased.

Referring now to the second embodiment shown in Figure 4, although the semiconductor device is applicable to the same circuit as shown in Figure 3, a different control circuit is illustrated in Figure 4. In Figure 4, the same parts bear the same reference numerals as in Figure 3. Also, all the semiconductor layers are formed by the diffusion process. Since the epitaxial technique is not required unlike the first embodiment shown in Figures 1 to 3, this second embodiment has a simplified manufacturing process and a reduced cost. The semiconductor device can be produced by the following steps. An $n^-$-type Si substrate having a pair of major surfaces is prepared, and phosphorus is diffused into the entire area from one of the major surfaces, to form an $n^+$-type layer 20. Subsequently boron is selectively diffused from the pair of major surfaces to form a p-type layer 17 and $p^+$-type regions 15 respectively. Subsequently, phosphorus is selectively diffused from the major surface formed with the p-type layer 17, to form an n-type layer 19. Further phosphorus is selectively diffused into the n-type layer 19 at a still higher concentration, to form an $n^+$-type layer 18. The impurity concentration of the n-type layer 19 needs to be made higher than that of the p-type layer 17. The silicon dioxide film 21 and the electrodes 12, 13 and 14 are the same as those in the first embodiment shown in Figures 1 to 3.

In order to attain a good contact between the p-type layer 17 and the control electrode 13, it is recommended to add a thin p⁺-type layer of high concentration to the contact surface of the p-type layer 17 with the control electrode 13.

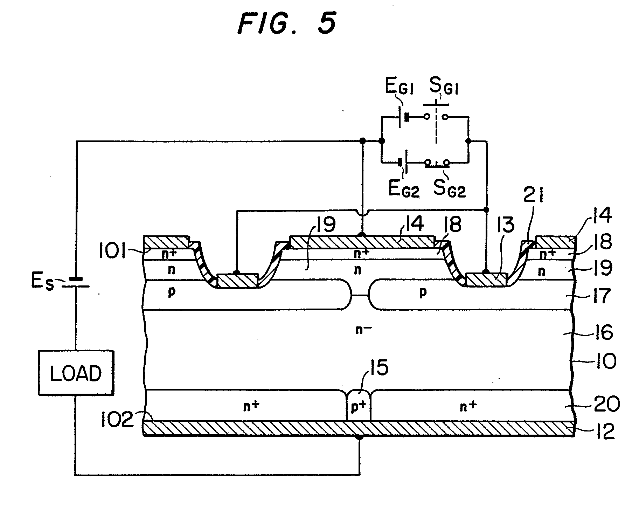

Referring now to the third embodiment shown in Figure 5, although the semiconductor device is applicable to the same circuit as shown in Figure 3, a further control circuit is illustrated in Figure 5. The semiconductor device is such that, in the first embodiment shown in Figures 1 to 3, portions corresponding to the p⁺-type regions 11 are removed by an etching process so as to form recesses extending from the major surface 101 to the p-type layer 17, whereupon the electrode 13 is formed on the bottoms of the recesses. Since, in this case, the control electrode 13 and the first main electrode 14 have a level difference corresponding to the depth of the recess, the device can be put into the so-called compression type in which a flat electrode is brought into pressed contact with the upper surface of the first main electrode 14 as an external electrode for connecting the first main electrode 14 to the exterior of the device. Illustrated in this embodiment is the case where the impurity concentrations and thicknesses of the p⁺-type region 15 and the n⁺-type layer 20 are equal.

Next, the control circuits for the semiconductor devices of the second and third embodiments will be described in greater detail.

In order to turn "on" the semiconductor device at high speed, not only the switch $S_G$ is opened as in the first embodiment of Figure 3, but also a voltage pulse to forward-bias a p-n junction defined between the n⁺-type layer 18 and the p⁺-type region 11 is impressed across the layer and the region. In order to achieve this, an arrangement shown in Figure 4 can be used wherein a reactor L or desirably a circuit consisting of a reactor L, a current limiting resistor R and a switch Sw connected in series is inserted between the main electrode 14 and the control electrode 13. In this circuit, the switch $S_G$ is "on" and the switch Sw is "off" in the "off" state of the semiconductor device. When the semiconductor device is to be turned "on" from the "off" state, the switch Sw is turned "on" to supply the reactor L with current from the power supply $E_G$ and to store energy therein. Subsequently, the switch $S_G$ is turned "off". The electric energy which has been stored in the reactor L forward-biases the pnn⁺ diode formed between the control electrode 13 and the main electrode 14 within the semiconductor body, so that electrons are injected from the n⁺-type layer 18. This injection promotes the turn-on of the semiconductor device.

Not only for the turn-on, but also during the "on" state of the semiconductor device, the path between the control electrode 13 and the main electrode 14 can be forward-biased. As example of such a driver circuit is shown in Figure 5. Such a method is effective especially in the case where the channel width is made small, since with the channel unbiased, pinch-off is established by the built-in potential between it and the semiconductor layer 17, thereby enhancing the turn-off characteristic. In such a case, although the turn-off characteristic is enhanced, the turn-on characteristic is liable to be sacrificed. In accordance with the circuit shown in Figure 5, a switch $S_{G1}$ is "on" and a switch $S_{G2}$ is "off" during the "off" state of the semi conductor device and the situation is the same as in the circuit of Figure 3 at this time. During the "on" state the switch $S_{G2}$ which is located in series with a second control power supply $E_{G2}$ whose polarity is opposite to that of a first control power supply $E_{G1}$ is "on", and the switch $S_{G1}$ is "off". Therefore, a voltage to forward-bias the p-n junction between the p-type layer 17 and the n-type layer 19 is applied across the main electrode 14 and the control electrode 13, and electrons are injected from the n⁺-type layer 18 into the n-type layer 19 and the p-type layer 17. This injection promotes the conduction of the diode between the pair of main electrodes.

The above described control circuits are not restricted to the particular semiconductor devices shown, since any one can be applied to any one of semiconductor devices shown.

It is advantageous that the impurity concentration of the n-type layer 19 is made higher than that of the n⁻-type layer 16 as in the first and second embodiments. Owing to this construction, when the transistor portion is to be turned "on" the injection of electrons from the n⁺-type layer 18 into the n⁻-type layer 16 is promoted, which shortens the turn-on time. This effect is noticeable especially in the transistor portion remote from the diode portion.

Various modifications will now be described.

Regarding the positional relationship between the diode portion (region *a* in Figure 3) and the transistor portions (regions *b* in Figure 3), it is preferable for making the switching characteristics of the transistor portions uniform that the diode portion is located substantially in the centre of the transistor portions as in the above described embodiments. However, it is not always necessary to locate the diode portion in the centre of the transistor portions. In addition, the diode portion may well be one consisting of a plurality of split regions. In other words, the channel does not always need to extend in the lengthwise direction of the n⁺-type layer 18 as illustrated in the embodiment of Figures 1 to 3. By way of example, the channels can be the shape of a plurality of circles which are spaced from one another by the p-type layer 17.

In the above described embodiments, all the p- and n-conductivity types of the various semiconductor layers and regions may of course be inverted. In that case, the polarities of the power

supply $E_S$ and the control power supply $E_G$ shown in Figure 3 have to be reversed.

Further, the plan pattern of the semiconductor layers and regions of the semiconductor device is not restricted to that shown in Figure 2. By way of example, the $n^+$-type layers 18 may well be arranged to radiate from a centre within a circular wafer.

## Claims

1. A semiconductor switch device comprising a semiconductor body (10), a pair of main electrodes (12, 14) and a control electrode (13) which are connected to said semiconductor body, wherein

said semiconductor body has a pair of opposing major surfaces (101 and 102) and includes: a first semiconductor region (18 and 19) of one conductivity type which is exposed to one of said major surfaces;

a second semiconductor region (17) of opposite conductivity type which adjoins said first semiconductor region and forms a first p-n junction with said first semiconductor region;

a third semiconductor region (16) of said one conductivity type which adjoins said first and second semiconductor regions and forms a second p-n junction with said second semiconductor region, and forms a channel region with said first semiconductor region;

a fourth semiconductor region (20) which adjoins said third semiconductor region, and is exposed to the other major surface of said semiconductor body,

said first main electrode (14) is connected to said first semiconductor region (18) of said semiconductor body;

said second main electrode (12) is connected to said fourth semiconductor region (20) of said semiconductor body; and

said control electrode (13) is connected to said second semiconductor region (17) of said semiconductor body;

characterized in that said switch device includes the following features:

said fourth semiconductor region (20) is of said one conductivity type and has an impurity concentration higher than that of said third semiconductor region;

said semiconductur body (10) has a fifth semiconductor region (15) of the said opposite conductivity type which is opposite to said channel region across said third semiconductor region (16) forming a third p-n junction therewith and adjoins said fourth semiconductor region (20), said fifth semiconductor region (15) is exposed to the other major surface (102) of said semiconductor body and is connected to said second main electrode (12), whereby there is constituted a diode between said pair of major surfaces by said first semiconductor region (18, 19) said third semiconductor region (16) including said channel region and said fifth semiconductor region (15), and also a transistor between said pair of major surfaces by said first semiconductor region (18, 19), said second semiconductor region (17), said third semiconductor region (16) and said fourth semiconductor region (20).

2. A semiconductor switch device according to claim 1, characterized in that the impurity concentration which determines said conductivity type of said first semiconductor region (18 and 19) is higher than that of said third semiconductor region (16) in a portion of said first semiconductor region contacting with said second semiconductor region (17), and wherein the impurity concentration in a portion (18) of said first semiconductor which is in contact with the first main electrode (14) is higher than the rest of the first semiconductor region.

3. A semiconductor switch device according to claim 1, characterized in that the diode is surrounded by the transistor.

4. A semiconductor switch device according to claim 1 characterized in that said fifth semiconductor region (15) protrudes from said fourth semiconductor region (20) towards said channel region.

5. A semiconductor switch device according to claim 1 characterized in that the sectional area of the transistor in a plane parallel to said major surfaces is larger than that of the diode.

6. A semiconductor switch device according to claim 1 characterized in that the width of said channel and the impurity concentration of said third semiconductor region or said second semiconductor region are determined in such a manner that in the vicinity of said first and third p-n junctions a depletion layer is formed by a built-in potential of said first p-n junction when no reverse-bias voltage is applied to said first and third p-n junctions, whereby said diode between said pair of major surfaces is held in a nonconductive state.

7. A semiconductor switch device according to claim 6, characterized in that said switch device additionally includes means to forward-bias said first and third p-n junctions when said semiconductor switch device is turned on and/or in the "on" state.

## Revendications

1. Dispositif de commutation à semi-conducteurs comprenant un corps semi-conducteur (10), une paire d'électrodes principales (12, 14) et une électrode de commande (13) qui sont connectées audit corps semi-conducteur, dispositif dans lequel:

ledit corps semi-conducteur possède une paire de surfaces majeures (101, 102) et il comporte:

une première région semi-conductrice (18 et 19) d'un premier type de conductivitié, qui est exposée à l'une desdites surfaces majeures;

une deuxième région semi-conductrice (17) de type opposé de conductivité qui est accolée à ladite première région semi-conductrice et forme une première jonction p-n avec ladite première région semi-conductrice;

une troisième région semi-conductrice (16) dudit premier type de conductivité qui est accolée auxdites première et deuxième régions semi-conductrices, et qui forme une deuxième jonction p-n avec ladite deuxième région semi-conductrice et une région de canal avec ladite première région semi-conductrice;

une quatrième région semi-conductrice (20) qui est accolée à ladite troisième région semi-conductrice et est exposée à l'autre surface majeure dudit corps semi-conducteur;

ladite première électrode principale (14) est connectée à ladite première région semi-conductrice (18) dudit corps semi-conducteur;

ladite deuxième électrode principale (12) est connectée à ladite quatrième région semi-conductrice (20) dudit corps semi-conducteur; et

ladite électrode de commande (13) est connectée à ladite deuxième région semi-conductrice (17) dudit corps semi-conducteur;

caractérisé en ce que ledit dispositif de commutation comporte les particularités suivantes:

ladite quatrième région semi-conductrice (20) est dudit premier type de conductivité et possède une concentration en impureté supérieure à celle de ladite troisième région semi-conductrice;

ledit corps semi-conducteur (10) possède une cinquième région semi-conductrice (15) dudit type opposé de conductivité qui fait face à ladite région de canal à travers ladite troisième région semi-conductrice (16) pour former avec cette dernière une troisième jonction p-n et est accolée à ladite quatrième région semi-conductrice (20), ladite cinquième région semi-conductrice (15) est exposée à l'autre surface majeure (102) dudit corps semi-conducteur et est connectée à ladite deuxième électrode principale (12), si bien qu'il est constitué une diode entre ladite paire de surfaces majeures par ladite première région semi-conductrice (18, 19), ladite troisième région semi-conductrice (16), comportant ladite région de canal, et ladite cinquième région semi-conductrice (15), et également un transistor entre ladite paire de surfaces majeures par ladite première région semi-conductrice (18, 19), ladite deuxième région semi-conductrice (17), ladite troisième région semi-conductrice (16) et ladite quatrième région semi-conductrice (20).

2. Dispositif de commutation à semi-conducteurs selon la revendication 1, caractérisé en ce que la concentration en impureté qui détermine ledit type de conductivité de ladite première région semi-conductrice (18 et 19) est supérieure à celle de ladite troisième région semi-conductrice (16) dans une partie de ladite première région semi-conductrice en contact avec ladite deuxième région semi-conductrice (17), et où la concentration en impureté existant dans une partie (18) dudit premier semi-conducteur qui est en contact avec la première électrode principale (14) est supérieure au reste de la première région semi-conductrice.

3. Dispositif de commutation à semi-conducteurs selon la revendication 1, caractérisé en ce que la diode est entourée par le transistor.

4. Dispositif de commutation à semi-conducteurs selon la revendication 1, caractérisé en ce que ladite cinquième région semi-conductrice (15) fait saillie de ladite quatrième région semi-conductrice (20) en direction de ladite région de canal.

5. Dispositif de commutation à semi-conducteurs selon la revendication 1, caractérisé en ce que l'aire en coupe du transistor dans un plan parallèle auxdites surfaces majeures est plus grande que celle de la diode.

6. Dispositif de commutation à semi-conducteur selon la revendication 1, caractérisé en ce que la largeur dudit canal et la concentration en impurete de ladite troisième région semi-conductrice ou de ladite deuxième région semi-conductrice sont déterminées de telle manière que, au voisinage desdites première et troisième jonctions p-n, une couche d'appauvrissement est formée par une tension interne de ladite première jonction p-n lorsque aucune tension de polarisation en sens inverse n'est appliquée auxdites première et troisième jonctions p-n, si bien que ladite diode existant entre ladite paire de surfaces majeures est maintenue dans un état nonconducteur.

7. Dispositif de commutation à semi-conducteurs selon la revendication 6, caractérisé en ce que ledit dispositif de commutation comporte en outre en moyen pour polariser en sens direct lesdites première et troisième jonctions p-n lorsque ledit dispositif de commutation à semi-conducteur est rendu conducteur et, ou bien, est placé dans l'état "conducteur".

**Patentansprüche**

1. Halbleiterschaltvorrichtung mit einem Halbleiterkörper (10), einem Paar von Hauptelektroden (12, 14) und einer Steuerelektrode (13), die mit dem Halbleiterkörper verbunden sind, wobei

der Halbleiterkörper ein Paar von einander gegenüberliegenden Hauptflächen (101 und 102) besitzt und aufweist: ein erstes Halbleitergebiet (18 und 19) von dem einen Leitfähigkeitstyp, das zu einer der Hauptoberflächen freiliegt;

ein zweites Halbleitergebiet (17) des entgegengesetzten Leitfähigkeitstyps, das an das erste Halbleitergebiet angrenzt und mit dem ersten Halbleitergebiet einen ersten p-n-Übergang bildet;

ein drittes Halbleitergebiet (16) des ersten Leitfähigkeitstyps, das an das erste und das zweite Halbleitergebiet angrenzt und mit dem zweiten Halbleitergebiet einen zweiten p-n-Übergang und mit dem ersten Halbleitergebiet ein Kanalgebiet bildet;

ein viertes Halbleitergebiet (20), das an das dritte Halbleitergebiet angrenzt und das zu der anderen Hauptfläche des Halbleiterkörpers freiliegt;

und wobei die erste Hauptelektrode (14) mit dem ersten Halbleitergebiet (18) des Halbleiterkörpers verbunden ist,

die zweite Hauptelektrode (12) mit dem vierten Halbleitergebiet (20) des Halbleiterkörpers verbunden ist,

und die Steuerelektrode (13) mit dem zweiten Halbleitergebiet (17) des Halbleiterkörpers verbunden ist,

dadurch gekennzeichnet, daß die Schaltvorrichtung folgende Merkmale aufweist:

das vierte Halbleitergebiet (20) besitzt den einen Leitfähigkeitstyp und eine Störstellenkonzentration, die höher ist als jene des dritten Halbleitergebietes;

der Halbleiterkörper (10) besitzt ein fünftes Halbleitergebiet (15) des entgegengesetzten Leitfähigkeitstyps, das dem Kanalgebiet gegenüberliegt und quer durch das dritte Halbleitergebiet (16) verläuft und mit ihm eine dritte p-n-Grenzschicht bildet und an das vierte Halbleitergebiet (20) angrenzt, wobei das fünfte Halbleitergebiet (15) zu der anderen Hauptoberfläche (102) das Halbleiterkörpers freiliegt und mit der zweiten Hauptelektrode (12) verbunden ist, so daß eine Diode zwischen dem Paar von Hauptoberflächen durch das erste Halbleitergebiet (18, 19), das das Kanalgebiet enthaltende dritte Halbleitergebiet (16) und das fünfte Halbleitergebiet (15) gebildet wird, und daß ebenfalls ein Transistor zwischen dem ersten Paar von Hauptoberflächen durch das erste Halbleitergebiet (18, 19), das zweite Halbleitergebiet (17), das dritte Halbleitergebiet (16) und das vierte Halbleitergebiet (20) gebildet wird.

2. Halbleiterschaltvorrichtung nach Anspruch 1, dadurch gekennzeichnet, daß die Störstellenkonzentration, die den Leitfähigkeitstyp des ersten Halbleitergebietes (18 und 19) bestimmt, höher ist als jene des dritten Halbleitergebietes (16) in einem Teil des ersten Halbleitergebietes, das mit dem zweiten Halbleitergebiet (17) in Kontakt steht, und wobei die Störstellenkonzentration in einem Teil (18) des ersten Halbleitergebietes, das in Kontakt mit der ersten Hauptelektrode (14) steht, höher ist als der Rest des ersten Halbleitergebietes.

3. Halbleiterschaltvorrichtung nach Anspruch 1, dadurch gekennzeichnet, daß die Diode von den Transistor umgeben ist.

4. Halbleiterschaltvorrichtung nach Anspruch 1, dadurch gekennzeichnet, daß das fünfte Halbleitergebiet (15) von dem vierten Halbleitergebiet (20) in Richtung auf das Kanalgebiet vorspringt.

5. Halbleiterschaltvorrichtung nach Anspruch 1, dadurch gekennzeichnet, daß die Querschnittsfläche des Transistors in einer zu den Hauptoberflächen parallelen Ebene größer ist als jene der Diode.

6. Halbleiterschaltvorrichtung nach Anspruch 1, dadurch gekennzeichnet, daß die Breite des Kanals und die Störstellenkonzentration des dritten Halbleitergebietes oder des zweiten Halbleitergebietes so bestimmt sind, daß in der Nachbarschaft der ersten und der dritten p-n-Grenzschicht eine Verarmungsschicht durch ein aufgebautes Potential der ersten p-n-Grenzschicht gebildet wird, wenn keine Rückwärts-Vorspannung an die erste und die dritte p-n-Grenzschicht angelegt wird, wodurch die zwischen den Hauptoberflächen befindliche Diode in einem nicht-leitenden Zustand gehalten wird.

7. Halbleiterschaltvorrichtung nach Anspruch 6, dadurch gekennzeichnet, daß die Schaltvorrichtung weiterhin eine Einrichtung aufweist, um die erste und die dritte p-n-Grenzschicht in Vorwärts-Richtung vorzuspannen, wenn die Halbleiterschaltvorrichtung eingeschaltet wird, und/oder in den Ein-Zustand gebracht wird.

## FIG. 1

## FIG. 2

FIG. 3

FIG. 4

# FIG. 5